# FASCICULE DE BREVET EUROPEEN

(11) **EP 2 065 336 B1**
(45) Date de publication et mention de la délivrance du brevet: **02.11.2011**
(21) Numéro de dépôt: 08168303.9
(22) Date de dépôt: 04.11.2008
(51) Int. Cl.: B81C 1/00

(54) **Procédé de realisation d'un dispositif à membrane suspendue**
Verfahren zur Herstellung einer Vorrichtung mit einer aufgehängten Membrane
Method for making a device with a suspended membrane

(30) Priorité: 09.11.2007 FR 0758915
(43) Date de publication de la demande: 03.06.2009
(73) Titulaire: Commissariat à l'Énergie Atomique et aux Énergies Alternatives, 75015 Paris (FR)
(72) Inventeur: Rey, Patrice, 38430, SAINT JEAN DE MOIRANS (FR); Salhi, Mouna, 38100, GRENOBLE (FR)
(74) Mandataire: Ilgart, Jean-Christophe

(56) Documents cités:
- DE-A1- 10 144 847
- DE-A1- 19 903 380
- KR-A- 20040 102 390

## Description

### DOMAINE TECHNIQUE

L'invention concerne le domaine des MEMS (microsystèmes électromécaniques) ou NEMS (nanosystèmes électromécaniques), et notamment celui des microcapteurs comportant des éléments suspendus réalisés en technologie de surface.

### ÉTAT DE LA TECHNIQUE ANTÉRIEURE

Il existe actuellement plusieurs procédés permettant de réaliser des MEMS comportant des portions de matériau suspendues appelées membranes suspendues.

Le document US 2004/0119125 décrit un procédé de réalisation d'une structure MEMS de surface à partir d'un substrat SOI (silicium sur isolant). Plusieurs ouvertures sont réalisées à travers la couche supérieure de silicium et la couche diélectrique du substrat SOI. Un matériau isolant et résistant à la gravure est déposé dans ces ouvertures, puis une couche de silicium est épitaxiée sur la couche supérieure de silicium du substrat SOI. La couche diélectrique est ensuite gravée, faisant ainsi reposer la couche épitaxiée sur des plots d'ancrage formés par le matériau isolant et reliés à la couche inférieure de silicium du substrat SOI.

Toutefois, il est parfois nécessaire de réaliser des membranes ne comportant pas de plots d'ancrage répartis sous celles-ci.

Le document US 5 510 276 décrit un procédé de réalisation d'un capteur de pression de surface. Ce capteur est réalisé à partir d'un substrat SOI. Une ouverture est réalisée à travers la couche supérieure de silicium du substrat SOI jusqu'à atteindre la couche isolante. La couche isolante est ensuite gravée par une solution à base d'acide fluorhydrique diffusée par l'ouverture précédemment réalisée. Cette gravure se propage de façon concentrique sous la couche supérieure de silicium. Cette gravure est stoppée lorsque le diamètre d'oxyde gravé souhaité est atteint.

Ce procédé permet de former des structures suspendues, c'est-à-dire des membranes suspendues, circulaires, dont l'ancrage est réalisé par une paroi périphérique d'oxyde se trouvant sous la partie suspendue de silicium.

Un tel procédé a notamment pour inconvénient d'utiliser le temps comme paramètre de contrôle dimensionnel de la structure suspendue réalisée. Or, étant donné que la vitesse de gravure dépend du pH de l'agent de gravure et que, pour un même agent de gravure, cette vitesse dépend de la température et de la composition du diélectrique gravé, ce procédé ne permet pas d'obtenir une caractérisation précise des dimensions de la structure réalisée.

De plus, avec ce procédé, l'ouverture par laquelle est diffusée la solution de gravure est disposée obligatoirement au centre de la membrane suspendue. Le bouchon utilisé ensuite pour refermer l'ouverture est à base d'un matériau différent de celui de la membrane, et peut donc être considéré comme un défaut pouvant altérer les propriétés mécaniques de la membrane. En particulier, dans le cas où cette membrane est un élément vibrant d'un microphone ou d'un transducteur ultrasonore, le bouchon peut induire des perturbations dans l'onde émise. Enfin, la forme de la membrane suspendue obtenue par ce procédé est obligatoirement circulaire.

D'autres procédés pour réaliser des portions de matériau suspendues sont divulgués dans les documents DE 199 03 380 A1, DE 101 44 847 A1 et KR 2004 0102390 A.

### EXPOSÉ DE L'INVENTION

Un but de la présente invention est de proposer un nouveau procédé de réalisation de membrane suspendue supprimant ou réduisant les inconvénients des procédés de l'art antérieur, c'est-à-dire offrant une meilleure précision dans la réalisation de la membrane suspendue, par exemple au niveau des dimensions et de la forme de la membrane réalisée, permettant d'obtenir des membranes suspendues de formes quelconques, limitant la dégradation des propriétés mécaniques de cette membrane due au procédé de réalisation, et améliorant les ancrages de la structure réalisée.

Pour cela, la présente invention propose un procédé de réalisation d'un dispositif à au moins une membrane suspendue, comportant au moins les étapes suivantes :
- réalisation d'une tranchée à travers une première couche sacrificielle et une seconde couche disposée sur la première couche sacrificielle, la tranchée entourant complètement au moins une partie de la première couche sacrificielle et au moins une partie de la seconde couche,
- remplissage de tout ou partie de la tranchée par au moins un matériau apte à résister à au moins un agent de gravure,
- gravure de ladite partie de la première couche sacrificielle par ledit agent de gravure à travers au moins une ouverture réalisée dans la seconde couche, ladite partie de la seconde couche formant au moins une partie de la membrane suspendue.

Dans ce procédé, la tranchée a donc un motif à contour fermé, permettant la réalisation d'un mur d'arrêt de gravure de la couche sacrificielle qui est par exemple la couche d'oxyde d'un substrat de type SOI. La tranchée remplie d'un matériau d'arrêt de gravure forme donc ce mur, délimitant géographiquement une zone fermée de la couche sacrificielle, entourée par ce mur. Le matériau du mur déposé dans la tranchée étant résistant à l'agent de gravure de la couche sacrificielle, ce mur joue le rôle d'une paroi d'arrêt de gravure.

Ainsi, on peut réaliser des membranes suspendues en matériau monocristallin à partir desquelles il est possible de construire des structures suspendues. De plus, ce procédé permet de réaliser des membranes suspendues dont les caractéristiques telles que la forme ou les dimensions souhaitées peuvent être plus précises qu'avec les procédés de l'art antérieur.

Ce procédé n'impose aucune contrainte sur la forme de la membrane suspendue.

Ce procédé autorise également un positionnement libre de trous d'accès à la couche sacrificielle. Ils seront situés de préférence dans des zones qui ne modifient pas les propriétés mécaniques de la structure (en bord de membrane par exemple pour les capteurs de pression). Ainsi, on limite la dégradation des propriétés mécaniques de la membrane suspendue due à ces trous d'accès.

La seconde couche peut comporter au moins un matériau semi-conducteur dont au moins une partie est avantageusement monocristallin.

Le procédé peut comporter en outre, avant l'étape de réalisation de la tranchée, une étape de réalisation d'au moins une électrode sous lesdites parties de la première couche sacrificielle et de la seconde couche par implantation ionique dans une troisième couche, la première couche sacrificielle et la seconde couche pouvant être disposées sur cette troisième couche.

Selon une variante, le procédé peut comporter en outre, avant l'étape de réalisation de la tranchée, une étape de réalisation d'au moins une électrode par au moins un dépôt d'un matériau électriquement conducteur apte à résister au moins au dit agent de gravure, par exemple du polysilicium, sur une troisième couche à base d'un matériau apte à résister au moins au dit agent de gravure, la première couche sacrificielle et la seconde couche pouvant être disposées sur la troisième couche, ladite partie de la première couche sacrificielle pouvant être disposée au moins sur une partie de l'électrode.

La réalisation de cette électrode permet la fabrication de capteurs ou d'actionneurs capacitifs dont la capacité de détection ou d'actionnement est formée par cette électrode et la membrane suspendue.

Le matériau disposé dans la tranchée peut être un matériau diélectrique. Ainsi, les couches réalisées au-dessus de la couche sacrificielle peuvent être isolées électriquement des couches situées sous la couche sacrificielle.

Le matériau apte à résister au moins au dit agent de gravure peut être un matériau électriquement conducteur. Dans ce cas, le ou les murs d'ancrage assurent une liaison électrique entre les couches situées au-dessous de la couche sacrificielle et les couches situées au-dessus de la couche sacrificielle.

Le procédé peut comporter en outre, entre l'étape de remplissage de la tranchée et l'étape de gravure de ladite partie de la première couche sacrificielle, une étape d'épitaxie non sélective sur la seconde couche et sur le matériau disposé dans la tranchée. Ainsi, on augmente l'épaisseur de la couche superficielle destinée à former la membrane suspendue.

Dans une variante de réalisation, le procédé peut comporter en outre, entre l'étape de remplissage de la tranchée et l'étape de gravure de ladite partie de la première couche sacrificielle, une étape de report d'un matériau sur la seconde couche et sur le matériau apte à résister au moins au dit agent de gravure disposé dans la tranchée, et éventuellement d'une étape d'amincissement du matériau reporté.

Le matériau reporté peut notamment être au moins en partie monocristallin, permettant d'obtenir un ancrage monocristallin de la membrane suspendue. On améliore ainsi la qualité de l'ancrage réalisé grâce à de meilleures propriétés mécaniques que celles obtenues avec un matériau polycristallin.

Le remplissage de la tranchée peut être obtenu par dépôt.

Dans une variante, le remplissage de la tranchée peut être obtenu par une étape d'épitaxie non sélective sur la seconde couche et dans la tranchée.

Le procédé peut comporter en outre, après l'étape de gravure, une étape de dépôt d'une couche de passivation sur le dispositif.

Enfin, le procédé peut comporter en outre, après l'étape de gravure, une étape de réalisation de contacts reliés électriquement à ladite partie de la seconde couche et/ou, lorsque le procédé comporte une étape de réalisation d'une électrode, à l'électrode.

Le remplissage de la tranchée peut être obtenu par au moins un premier dépôt du matériau résistant au dit agent de gravure et par un deuxième dépôt d'un autre matériau dans la tranchée.

Le remplissage de la tranchée peut être réalisé par un premier dépôt d'un matériau diélectrique et par un deuxième dépôt dudit matériau résistant au dit agent de gravure. Cette variante permet notamment, lorsque le matériau résistant au dit agent de gravure est électriquement conducteur, d'isoler électriquement l'ancrage du reste du substrat par le premier dépôt diélectrique.

Ainsi, il est possible d'optimiser le remplissage de la tranchée, notamment lorsque celle-ci est large, ou en fonction du rôle destiné à être joué par le mur d'ancrage (support et/ou conduction de signaux électriques). Plusieurs matériaux différents peuvent donc être disposés dans la tranchée.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 7 représentent les étapes d'un procédé de réalisation d'un dispositif à membrane suspendue selon un premier mode de réalisation de l'invention,
- les figures 8 à 28 représentent les étapes d'un procédé de réalisation d'un dispositif à membrane suspendue selon un second mode de réalisation de l'invention,
- les figures 29 à 39 représentent les étapes d'un procédé de réalisation d'un dispositif à membrane suspendue selon un troisième mode de réalisation de l'invention,
- les figures 40 à 47 représentent les étapes d'un premier exemple de remplissage de tranchée mis en oeuvre lors d'un procédé de réalisation d'un dispositif à membrane suspendue, objet de la présente invention,
- la figure 48 représente un dispositif obtenu par une variante du premier exemple de remplissage de tranchée mis en oeuvre lors d'un procédé de réalisation d'un dispositif à membrane suspendue, objet de la présente invention,
- les figures 49 à 53 représentent une partie des étapes d'un second exemple de remplissage de tranchée mis en oeuvre lors d'un procédé de réalisation d'un dispositif à membrane suspendue, objet de la présente invention,
- la figure 54 représente un dispositif obtenu par une variante du second exemple de remplissage de tranchée mis en oeuvre lors d'un procédé de réalisation d'un dispositif à membrane suspendue, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

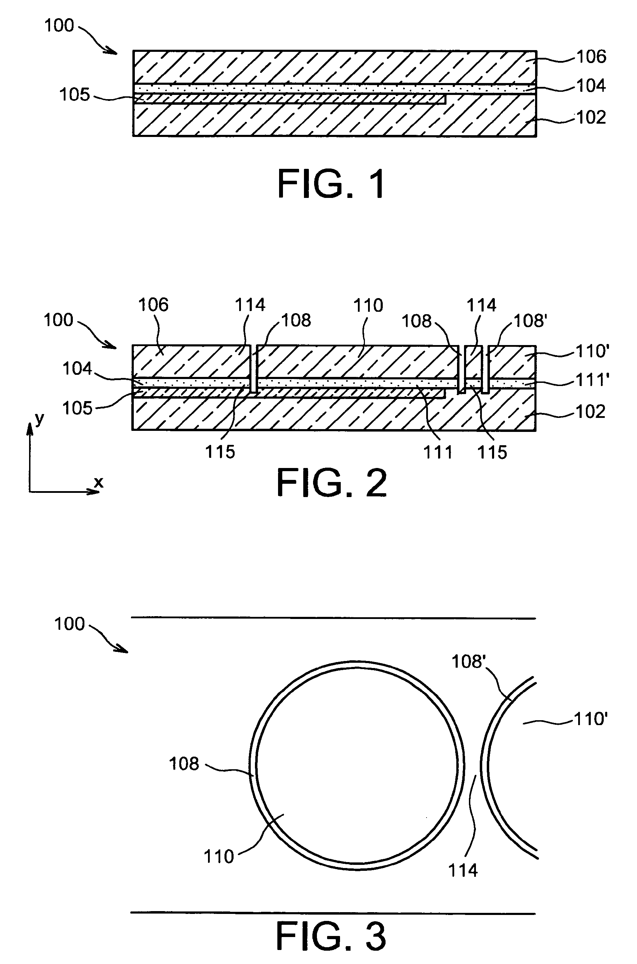

On se réfère tout d'abord aux figures 1 à 7 qui représentent les étapes d'un procédé de réalisation d'un dispositif 100 à membrane suspendue selon un premier mode de réalisation.

Le dispositif 100 est réalisé à partir d'un substrat 102 à base d'un semi-conducteur tel que du silicium, sur lequel sont empilées une couche diélectrique 104, par exemple à base de SiO₂ et formant une couche sacrificielle d'épaisseur égale à environ 1 µm,ou plus généralement comprise entre environ 0,1 µm et 3 µm, et une couche mince 106 à base d'un matériau semi-conducteur, par exemple du silicium monocristallin. Dans une variante, la couche 106 peut être à base d'un matériau semi-conducteur autre que du silicium, tel que par exemple du SiC (carbure de silicium) ou d'un matériau piézoélectrique tel que du LiNbO₃ (niobiate de lithium) ou du BaTiO₃ (titanate de baryum). La couche de semi-conducteur 106 a ici une épaisseur inférieure à environ 10 µm, ou comprise entre environ 0,1 µm et plusieurs dizaines de micromètres, ou inférieure à environ 100 µm. Dans ce premier mode de réalisation, le substrat 102, la couche sacrificielle 104 et la couche de semi-conducteur 106 forment un substrat SOI avantageusement monocristallin.

Comme représenté sur la figure 1, on peut réaliser une implantation ionique de dopants de type P ou N selon que le substrat 102 soit de type respectivement N ou P, formant une zone dopée 105 dans le substrat 102. Cette zone dopée 105 de silicium forme avec le reste du substrat 102 une jonction PN. Par exemple, dans le cas d'une implantation de Bore à travers une couche sacrificielle 104 à base de SiO₂ d'épaisseur égale à environ 230 nm et une couche de semi-conducteur 106 à base de silicium et d'épaisseur égale à environ 120 nm, l'épaisseur de la zone dopée 105 est par exemple égale à environ 0,3 µm. Cette implantation est par exemple réalisée avec des faisceaux d'ions d'énergie égale à environ 100 keV, la dose implantée étant égale à environ 3.10¹⁵ atomes/cm². De manière générale, l'épaisseur de la couche de semi-conducteur 106 et celle de la couche sacrificielle 104 peuvent être par exemple suffisamment faibles pour permettre une implantation ionique à travers ces couches.

Cette implantation ionique peut être utilisée pour réaliser des électrodes enterrées dans le substrat 102, pouvant par exemple être utilisées pour la réalisation d'une détection ou d'un actionnement capacitif entre une ou plusieurs de ces électrodes enterrées, se trouvant sous la membrane suspendue du dispositif, et ladite membrane suspendue.

Comme représenté sur la figure 2, on réalise ensuite une gravure dans la couche de semi-conducteur 106 et la couche sacrificielle 104, formant une tranchée 108. La couche de semi-conducteur 106 et la couche sacrificielle 104 sont complètement traversées par la tranchée 108. Cette tranchée 108 peut également être réalisée en partie dans le substrat 102. Sur la figure 3 (vue de dessus du dispositif 100), on voit que la tranchée 108 est réalisée selon un tracé continu, entourant complètement et délimitant une partie 110 de la couche de semi-conducteur 106, destinée à former au moins une partie de la membrane suspendue du dispositif 100. A titre d'exemple, une seconde tranchée 108' délimitant une deuxième partie 110' de la couche de semi-conducteur 106, destinée à former une seconde membrane suspendue du dispositif 100, est représentée partiellement sur les figures 2 et 3. La tranchée 108 entoure également complètement une partie 111 de la couche sacrificielle 104 se trouvant sous la partie 110 de la couche de semi-conducteur 106. De même, la tranchée 108' délimite une partie 111' de la couche sacrificielle 104 se trouvant sous la partie 110' de la couche de semi-conducteur 106. La zone dopée 105 se trouve au moins partiellement sous la partie 110 de la couche de semi-conducteur 106. La tranchée 108 a par exemple une largeur (dimension selon l'axe x représenté sur la figure 2) comprise entre environ 1 µm et 2 µm.

Le motif formé par la tranchée 108 peut être différent d'un cercle, par exemple rectangulaire, hexagonale, ou tout autre forme formant un contour continue et fermé de la partie 110 de la couche de semi-conducteur 106.

Dans ce premier mode de réalisation, une partie 114 de la couche de semi-conducteur 106 et une partie 115 de la couche sacrificielle 104, adjacentes à la tranchée 108, sont destinées à former un mur d'ancrage de la ou des membranes suspendues au reste du dispositif 100. Ces tranchées 108 peuvent par exemple être réalisées par une gravure ionique réactive (RIE).

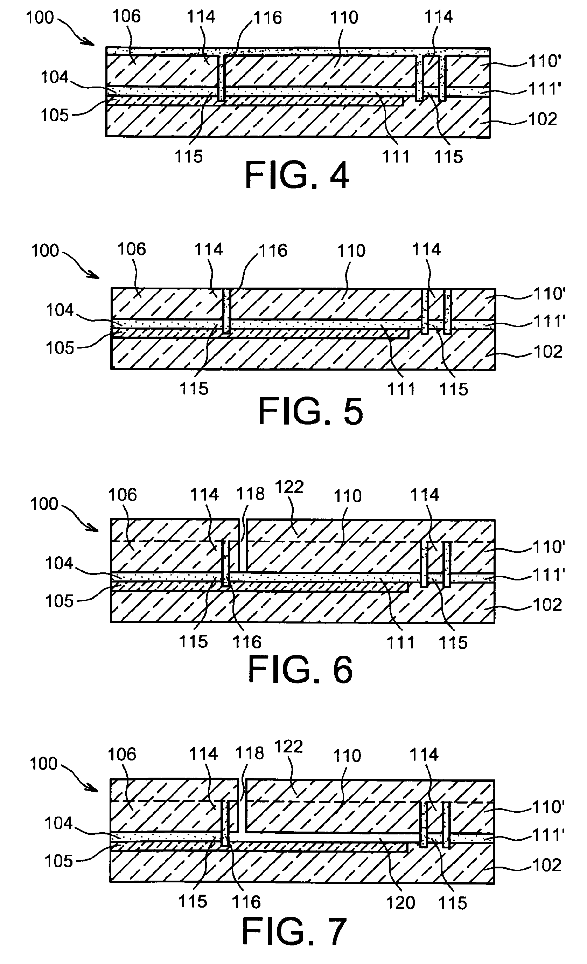

Sur la figure 4, les tranchées 108 et 108' sont ensuite remplies par un matériau d'arrêt de gravure 116 résistant à un ou plusieurs agents de gravure qui seront utilisés ultérieurement dans ce procédé pour graver la partie 111 de la couche sacrificielle 104. Ce matériau d'arrêt de gravure est par exemple déposé par PECVD (dépôt chimique en phase vapeur assisté par plasma) ou LPCVD (dépôt chimique en phase vapeur basse pression). Cette gravure ultérieure étant sélective, les matériaux de la couche de semi-conducteur 106, de la couche sacrificielle 104 ainsi que le matériau 116 d'arrêt de gravure sont choisis pour que l'agent de gravure grave le matériau de la couche sacrificielle 104 sans graver le matériau d'arrêt de gravure 116 disposé dans les tranchées 108, 108' ni celui de la couche de semi-conducteur 106. Dans ce premier mode de réalisation, le matériau d'arrêt de gravure 116 est déposé sur une épaisseur par exemple égale à la largeur de la tranchée 108.

Le tableau ci-dessous donne des exemples de couples de matériaux de la couche sacrificielle 104 et de matériaux d'arrêt de gravure 116 utilisables en fonction de l'agent de gravure. La sélectivité d'un agent de gravure pour un premier matériau par rapport à un second matériau est définie comme le rapport de la vitesse de gravure du premier matériau par rapport à celle du second matériau.

| Couche sacrificielle 104 | Agent de gravure | Matériau d'arrêt de gravure 116 | Sélectivité |
|---|---|---|---|
| SiO₂ | HF concentré, | Si₃N₄ | 1000 |
| | | SiN riche en Si | 5000 |
| | HF vapeur, | AlN | 500 |
| | HF tamponné | Si | infinie |
| Si, polySi | XeF₂ | SiO₂, Al, Ni, MgO, 2nO, Alumine, Verre, Ch | Supérieure à 1500 |
| Ti | HF concentré, HF vapeur, HF tamponné | Si₃N₄ | Supérieure à 1500 |
| | | SiN riche en Si | |
| | | AlN | |
| | | Si | |

Dans l'exemple de réalisation décrit ici, le matériau d'arrêt de gravure 116 est par exemple à base de SiN riche en silicium. Le SiN riche en silicium est du nitrure de silicium non-stoechiométrique obtenu par exemple par dépôt LPCVD (dépôt chimique en phase vapeur à basse pression). La sur-stoechiométrie en silicium de ce matériau est obtenue en augmentant le débit de dichlorosilane par rapport au débit de NH3 lors de la réalisation du SiN. Ce nitrure est aussi appelé « SiN low stress ».

Sur la figure 4, on voit que le matériau d'arrêt de gravure 116 est également déposé sur la couche 106 de semi-conducteur. On réalise alors, comme représenté sur la figure 5, une gravure permettant de supprimer les portions du matériau d'arrêt de gravure 116 se trouvant en dehors des tranchées 108, 108', également appelée gravure d'arasement ou gravure pleine tranche sans lithographie. Cette gravure est par exemple de type RIE (gravure ionique réactive).

Comme on peut le voir sur la figure 6, on peut, pour certaines applications, réaliser ensuite une épitaxie non sélective par rapport au matériau d'arrêt de gravure 116 sur la couche de semi-conducteur 106 et sur les portions du matériau d'arrêt de gravure 116, formant une couche 122 par exemple à base du même matériau que celui de la couche 106, par exemple du silicium monocristallin ou polycristallin selon la nature du matériau sur lequel est réalisé l'épitaxie. Ainsi, on augmente l'épaisseur de matériau semi-conducteur formée initialement par la couche de semi-conducteur 106 pour obtenir l'épaisseur requise à la réalisation de la membrane suspendue du dispositif 100.

Ainsi, il n'est pas nécessaire que la couche 106 initiale ait l'épaisseur souhaitée de la membrane suspendue que l'on réalise. L'augmentation de l'épaisseur de matériau se trouvant au-dessus de la couche sacrificielle 104 après la réalisation de l'implantation ionique dans le substrat 102 permet notamment d'avoir, lors de la mise en oeuvre de l'implantation, une épaisseur de matériaux compatible avec les énergies disponibles pour réaliser cette implantation à travers la couche diélectrique 104 et la couche de semi-conducteur 106.

Dans une variante, l'épaississement de la couche de semi-conducteur 106 peut être réalisé par un report, par exemple obtenu par collage, suivi éventuellement d'un amincissement, d'un substrat ou d'un film de matériau 122 reporté sur la couche de semi-conducteur 106. La couche 122 peut notamment être à base de semi-conducteur, par exemple du silicium, monocristallin ou non. Ainsi, il est possible d'avoir, à la fin du procédé de réalisation, une membrane qui soit entièrement à base de semi-conducteur monocristallin, y compris au niveau des portions 116 du matériau d'arrêt de gravure, c'est-à-dire à proximité des portions d'ancrage de la membrane, là où les contraintes mécaniques sont les plus importantes lorsque la membrane est par exemple en flexion. Le caractère monocristallin apporte de meilleures propriétés mécaniques à la membrane par rapport à du semi-conducteur polycristallin qui comporte une limite de rupture inférieure à celle d'un semi-conducteur monocristallin. Le contrôle de l'épaisseur résiduelle d'une couche reportée sur la couche de semi-conducteur 106 après amincissement peut être facilité par l'utilisation d'un substrat SOI dont la couche de semi-conducteur superficielle (disposée sur la couche d'oxyde) est telle qu'après collage et suppression de la couche inférieure de silicium et de la couche d'oxyde du substrat SOI reporté, l'épaisseur totale de semi-conducteur (épaisseur de la couche de semi-conducteur 106 + épaisseur de la couche de semi-conducteur superficielle) soit égale à l'épaisseur requise pour le composant à fabriquer.

Quelque soit la variante choisie pour obtenir l'épaisseur de membrane souhaitée, on grave ensuite au moins une ouverture 118, ici un trou d'accès, à travers la partie 110 de la couche de semi-conducteur 106, ainsi qu'à travers la couche 122. Cette ouverture 118 est par exemple réalisée par gravure RIE. Les dimensions de la section de l'ouverture 118 dans le plan principal de la couche 122 (par exemple le diamètre ou la longueur des côtés) sont par exemple comprises entre environ 0,3 µm à quelques micromètres, c'est-à-dire inférieures à environ 10 µm. Cette ouverture 118 permet d'accéder à la partie 111 de la couche sacrificielle 104 entourée par le matériau d'arrêt de gravure 116. L'ouverture 118 peut être réalisée n'importe où dans la partie 110 de la couche de semi-conducteur 106, et de préférence à proximité du matériau d'arrêt de gravure 116 pour éviter le centre de la partie 110. Il est également possible de réaliser d'autres ouvertures à travers la couche épitaxiée 122 et la couche de semi-conducteur 106, afin de supprimer d'autres parties de la couche sacrificielle 104 que la partie 111.

Enfin, comme représenté sur la figure 7, on grave alors la partie 111 de la couche sacrificielle 104 se trouvant au-dessous de la partie 110 de la couche de semi-conducteur 106. Après cette gravure, on obtient donc un espace vide 120, ou cavité, à la place de la partie 111 de la couche sacrificielle 104. La gravure s'arrête donc lorsque l'agent de gravure atteint le matériau d'arrêt de gravure 116. On peut par exemple utiliser une solution aqueuse à base de fluorure d'hydrogène (HF) diffusée sur la partie 111 de la couche sacrificielle 104 par l'intermédiaire de l'ouverture 118 pour réaliser cette gravure.

Ainsi, la partie 110 de la couche de semi-conducteur 106 est libérée du substrat 102, et est maintenue au dispositif 100 par l'intermédiaire de la couche épitaxiée 122 au reste de la couche de semi-conducteur 106, et notamment des parties 114 formant des zones d'ancrage. On obtient ainsi un dispositif 100 à membrane suspendue.

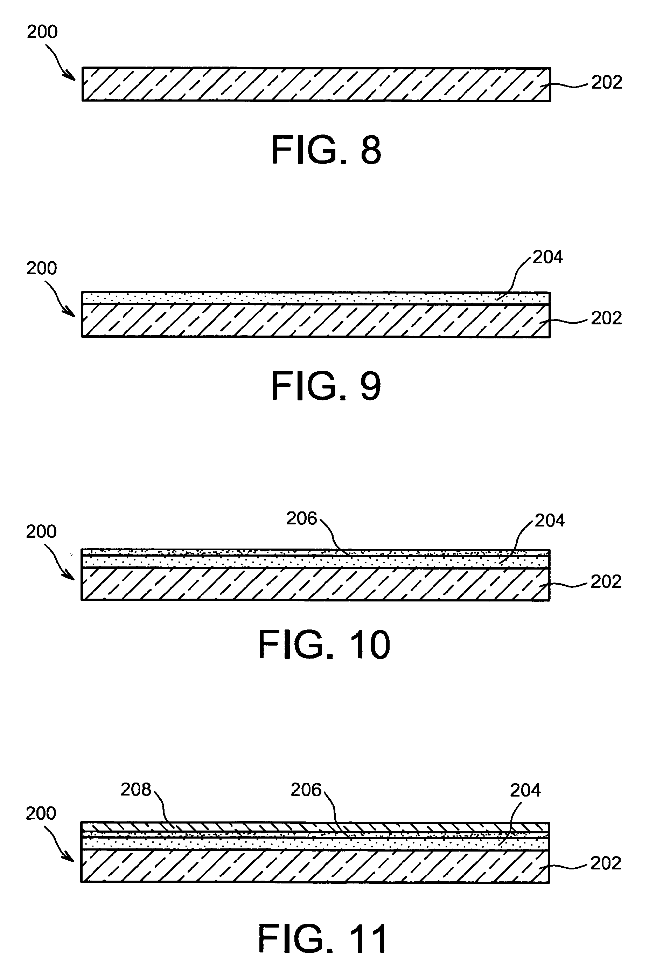

Les figures 8 à 28 représentent les étapes d'un procédé de réalisation d'un dispositif 200 à membrane suspendue selon un second mode de réalisation. Dans ce second mode de réalisation, le dispositif 200 est par exemple un capteur de pression à détection capacitive.

Le dispositif 200 est réalisé à partir d'un substrat 202 à base d'un semi-conducteur, ici du silicium (figure 8).

Ce substrat 202 est soumis à une oxydation thermique, formant sur celui-ci une couche 204 à base de SiO₂. Sur l'exemple de la figure 9, la couche 204 a par exemple une épaisseur égale à environ 1 µm. De manière générale, cette couche 204 peut avoir une épaisseur comprise entre environ 0,1 µm et 2 µm.

Comme représenté sur la figure 10, on réalise alors, sur la couche d'oxyde 204, un dépôt, par exemple de type LPCVD ou PECVD, d'une couche 206 à base d'un matériau résistant à au moins un agent de gravure qui sera utilisé ultérieurement au cours du procédé. Sur la figure 10, la couche 206 est à base de « SiN low stress », c'est-à-dire du matériau d'arrêt de gravure 116 utilisé dans le premier mode de réalisation. L'épaisseur de la couche 206 choisie dépend de la vitesse à laquelle le matériau de la couche 206 est gravé par l'agent de gravure et de la durée de la gravure. Dans le cas d'une gravure de type HF (au fluorure d'hydrogène), le rôle de la couche 206 est également de protéger la couche d'oxyde 204. Cette couche 206 a par exemple une épaisseur égale à environ 0,3 µm lorsque l'épaisseur du matériau à graver est par exemple égale à 20 µm.

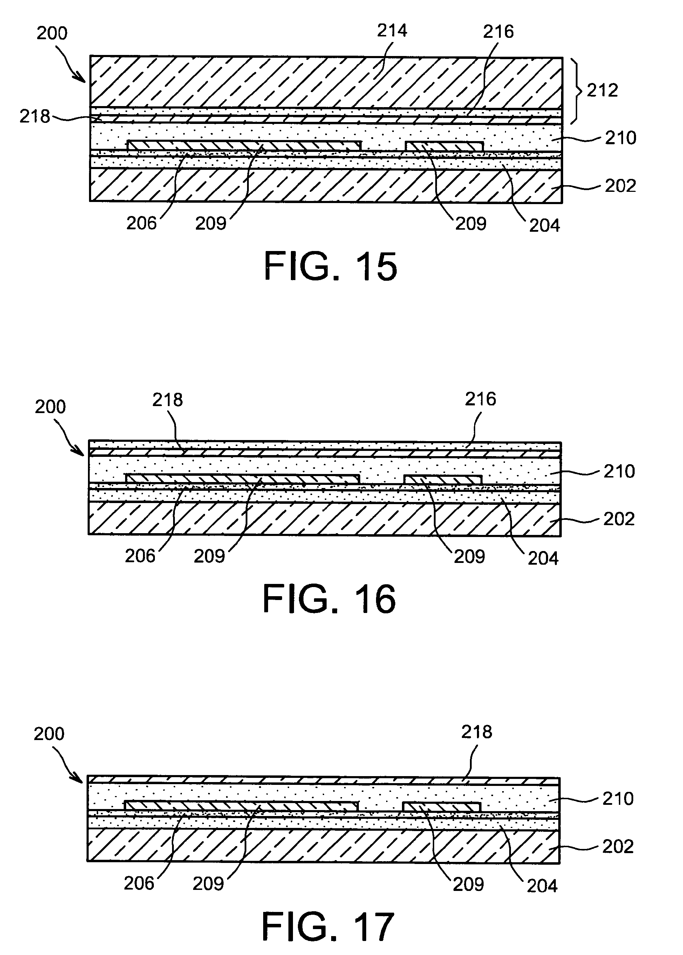

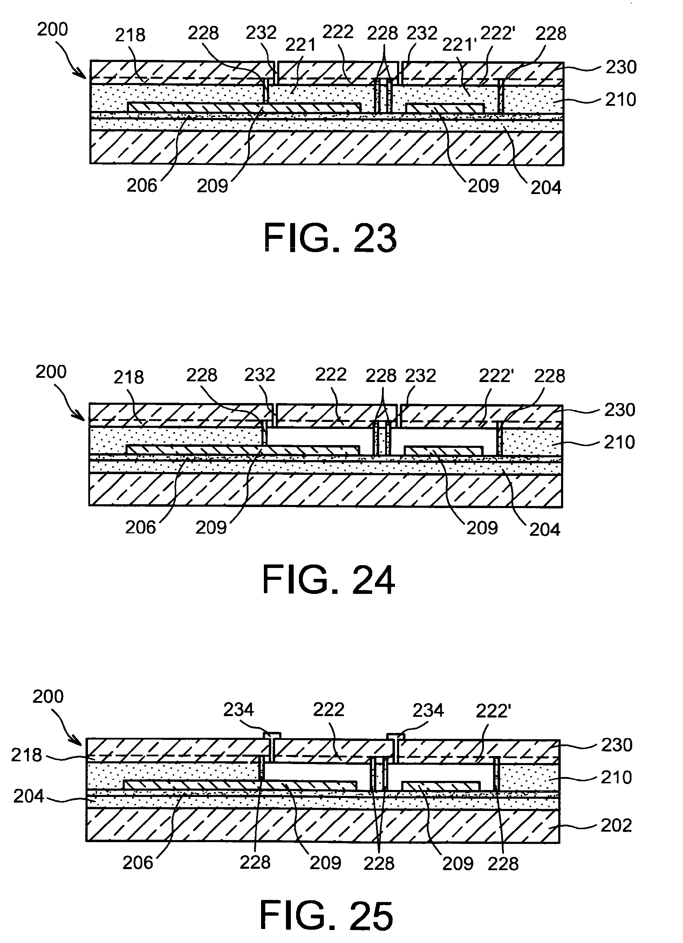

Comme représenté sur la figure 11, on dépose alors une couche 208 à base d'un matériau électriquement conducteur, par exemple à base de polysilicium. Ce dépôt peut être de type LPCVD. La couche 208 a une épaisseur égale à environ 0,35 µm, ou plus généralement comprise entre environ 0,1 µm et 1 µm. Le matériau de cette couche 208 est choisi pour être résistant à un agent de gravure utilisé ultérieurement dans le procédé de réalisation de la membrane suspendue (voir figure 24), et pouvant supporter la température d'un scellement également réalisé ultérieurement au cours du procédé (voir figure 15).

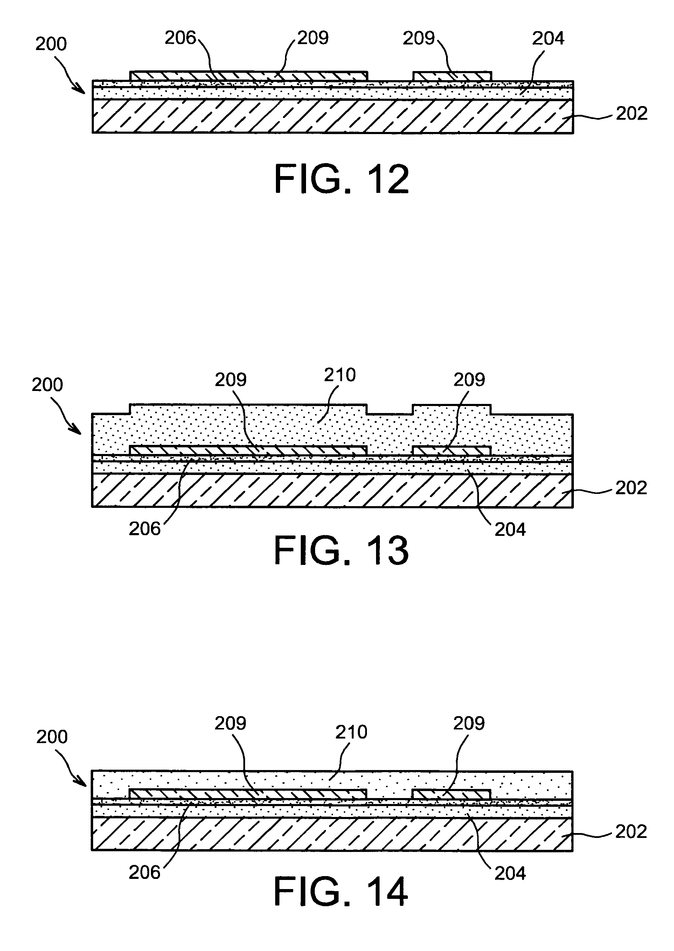

On grave ensuite la couche électriquement conductrice 208 tel que les portions restantes 209 de cette couche électriquement conductrice 208 soient destinées à former des électrodes inférieures du dispositif 200 pouvant être utilisées avec la membrane suspendue du dispositif 200 (voir figure 12).

Comme représenté sur la figure 13, on réalise un dépôt d'une couche 210 à base d'un matériau destiné à être gravé ultérieurement au cours du procédé par un agent de gravure, et ainsi former une couche sacrificielle 210. Dans ce second mode de réalisation, la couche sacrificielle 210 est par exemple à base de tétraorthosilicate d'éthyle, également appelé oxyde TEOS. La couche sacrificielle 210 peut également être à base d'un ou plusieurs des matériaux utilisables pour la couche sacrificielle 104 cités dans le premier mode de réalisation. Cette couche sacrificielle 210 est ensuite planarisée (figure 14).

On réalise alors un report, sur la couche sacrificielle 210, d'un substrat SOI 212 comportant un substrat 214 à base d'un semi-conducteur, par exemple du silicium, une couche d'oxyde 216 tel que du SiO₂ et une couche de semi-conducteur 218, par exemple du silicium monocristallin. Ce report est par exemple réalisé par un collage moléculaire entre la couche de silicium 218 et la couche sacrificielle 210.

Sur la figure 16, on réalise un amincissement du substrat 212 reporté, en s'arrêtant sur la couche de SiO₂ 216, supprimant ainsi le substrat 214. La couche de SiO₂ 216 est ensuite supprimée par gravure (figure 17).

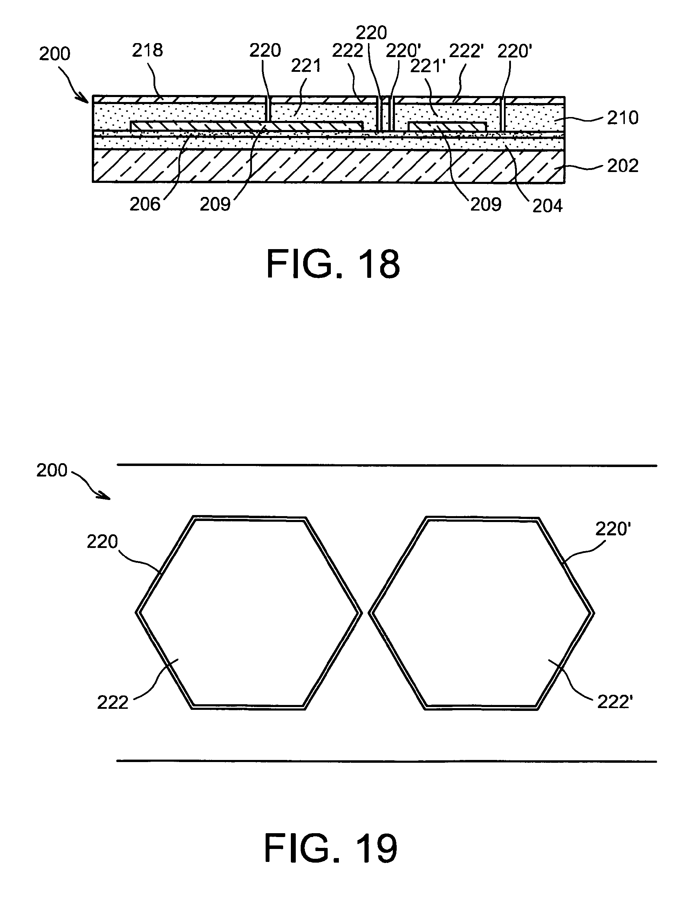

Comme dans le premier mode de réalisation, une tranchée 220 est réalisée à travers la couche de silicium 218 ainsi qu'à travers la couche sacrificielle 210 (figure 18). La tranchée 220 forme un contour fermé, délimitant une partie 222 de la couche de silicium 218 destinée à former une membrane suspendue du dispositif 200. Une autre tranchée 220' délimitant une autre partie 222' de la couche de silicium 218 destinée à former une seconde membrane est également représentée.

La figure 19 représente une vue de dessus du dispositif 200 après l'étape de réalisation des tranchées 220 et 220'. On voit que les parties 222 et 222' ont chacune une forme hexagonale complètement entourée respectivement par la tranchée 220 et 220'. La réalisation de plusieurs membranes, disposées les unes à côté des autres, notamment de forme hexagonale, permet de réaliser un réseau de membranes en nid d'abeille.

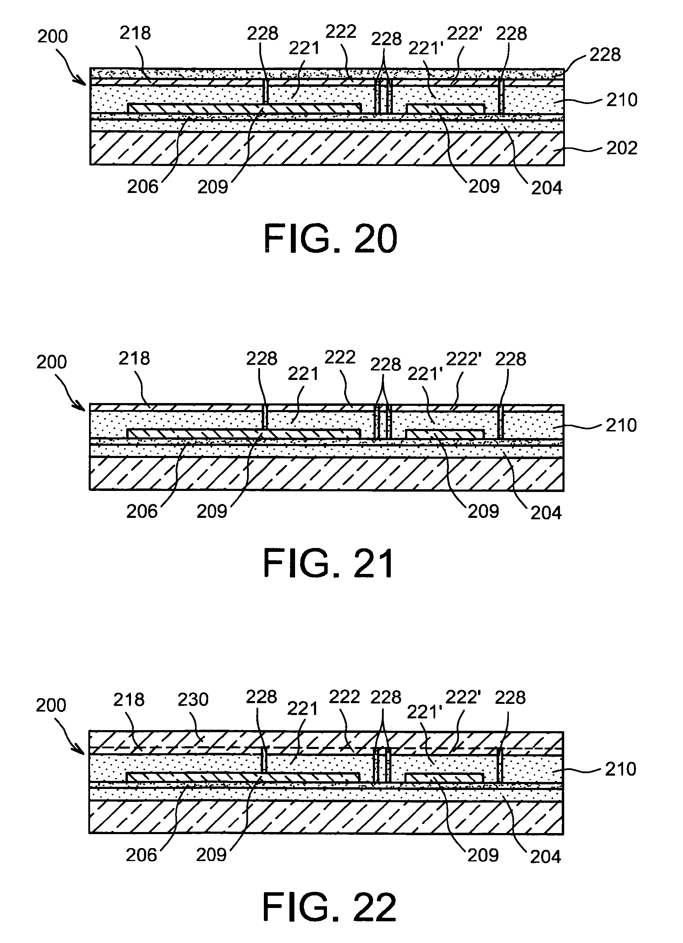

Comme dans le premier mode de réalisation, on dépose alors un matériau d'arrêt de gravure 228 sur la couche de silicium 218 et dans les tranchées 220, 220' (figure 20). Dans ce second mode de réalisation, le matériau 228 est à base de « SiN low stress ». L'épaisseur de la couche du matériau 228 est ici sensiblement égale à la largeur des tranchées 220, 220' réalisées. On réalise ensuite une gravure d'arasement, supprimant ainsi le matériau 228 ne se trouvant pas dans les tranchées 220 et 220' (figure 21).

De manière analogue au premier mode de réalisation, on réalise alors une épitaxie formant une couche 230 à base du semi-conducteur, par exemple du silicium, de la couche 218, sur cette couche 218 et sur les portions du matériau d'arrêt de gravure 228 (figure 22). Il est également possible de remplacer l'étape d'épitaxie par un collage moléculaire d'une couche (ou substrat) de semi-conducteur, puis de réaliser éventuellement un amincissement de cette couche ou de ce substrat.

Comme représenté sur la figure 23, on réalise par gravure des ouvertures 232 à travers les parties 222, 222' de la couche de silicium 218, ainsi qu'à travers la couche épitaxiée 230. Ces ouvertures 232 permettent d'accéder aux parties 221, 221' de la couche sacrificielle 210 entourées par le matériau d'arrêt de gravure 228.

Les parties 221, 221' de la couche sacrificielle 210 entourées par le matériau d'arrêt de gravure 228 sont alors gravées par une solution aqueuse à base de HF. On obtient donc des espaces vides à la place des parties 222, 222' de la couche sacrificielle 210. La gravure s'arrête donc lorsque l'agent de gravure atteint le matériau d'arrêt de gravure 228 (figure 24).

Ainsi, les parties 222, 222' de la couche de semi-conducteur 218 sont libérées partiellement du substrat 202, et maintenues au dispositif 200 par l'intermédiaire de la couche épitaxiée 230 au reste de la couche de semi-conducteur 218, et notamment des parties de la couche sacrificielle 210 se trouvant adjacentes aux tranchées 228, formant des zones d'ancrage.

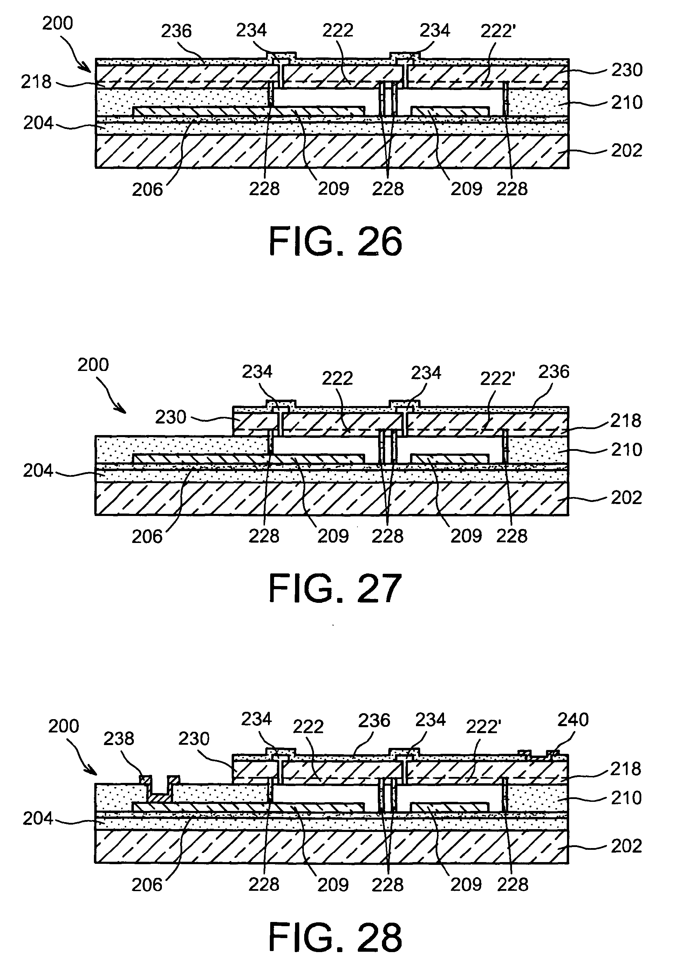

Les ouvertures 232 sont ensuite bouchées, par exemple par le dépôt et la gravure d'un matériau 234 tel que du verre de phosphosilicate (PSG) (figure 25). Comme représenté sur la figure 26, une couche de passivation 236 par exemple à base d'un matériau diélectrique est ensuite déposée sur le dispositif 200, c'est-à-dire sur la couche épitaxiée 230 et sur le matériau de bouchage 234.

Les parties des couches 218, 230 et 236 qui ne sont pas destinées à faire partie de la membrane suspendue ou du reste du dispositif 200 sont alors gravées (figure 27). Il est ensuite possible de graver la couche sacrificielle 210 afin d'accéder aux électrodes inférieures 209, et de réaliser une métallisation de contact 238 d'une électrode inférieure 209. Une métallisation 240 est également réalisée à travers la couche de passivation 236 pour contacter la couche épitaxiée 230 (figure 28).

Ce second mode de réalisation permet notamment de réaliser un adressage électrique différent des électrodes 209, par exemple à base de silicium polycristallin. En effet, dans le premier mode de réalisation, la jonction PN formée par les électrodes inférieures en silicium implantée et le substrat est bloquée et fait appel à une polarisation supplémentaire du substrat, ce qui n'est pas le cas dans ce second mode de réalisation. De plus, le dispositif 200 selon le second mode de réalisation peut être utilisé à une température plus élevée que le dispositif 100 décrit précédemment, car la température d'utilisation n'est pas limitée par les fuites de courant des jonctions PN pouvant apparaître au-delà de 100°C.

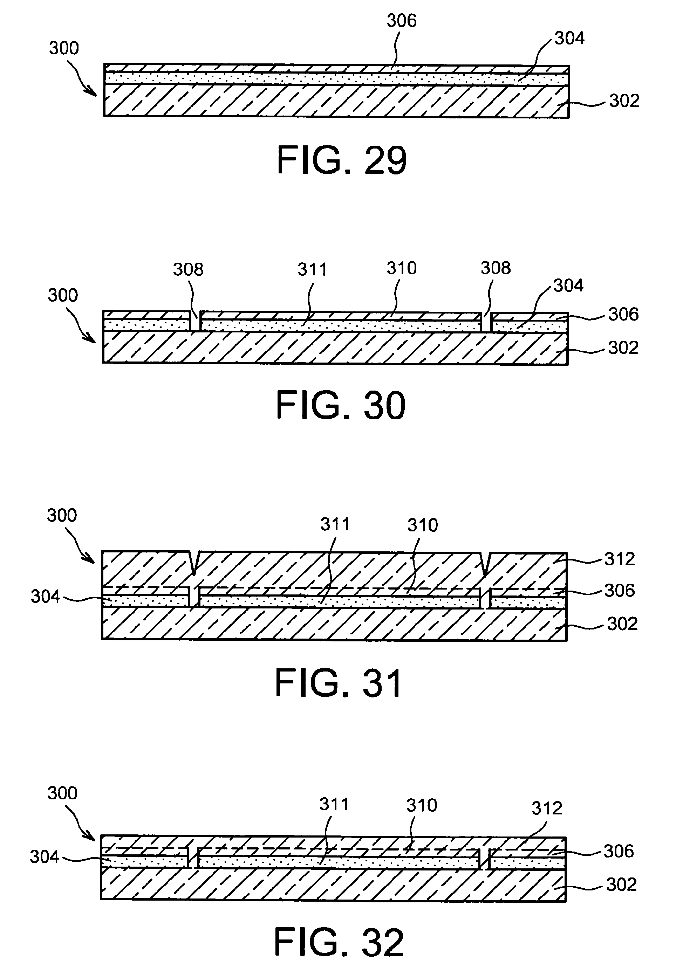

Lorsque la membrane suspendue du dispositif n'est pas isolée électriquement du substrat ou lorsqu'une ou plusieurs connexions électriques sont formées sur cette structure, les parois d'arrêt de gravure peuvent être en matériau conducteur ou semi-conducteur. Ce cas est décrit en liaison avec les figures 29 à 39 représentant les étapes d'un procédé de réalisation d'un dispositif 300 à membrane suspendue selon un troisième mode de réalisation. Dans ce troisième mode de réalisation, le dispositif 300 est un capteur de pression à membrane, par exemple monocristalline, à détection piézorésistive.

A partir d'un substrat SOI comportant un substrat 302, une couche diélectrique 304 et une couche à base de semi-conducteur 306, ici du silicium monocristallin, par exemple similaire au substrat SOI décrit en liaison avec la figure 1, et représenté sur la figure 29, on grave une tranchée 308 dans la couche de semi-conducteur 306 et la couche diélectrique 304, qui est une couche sacrificielle (figure 30). La tranchée 308 est réalisée selon un tracé continu, entourant complètement et délimitant une première partie 310 de la couche de semi-conducteur 306 destinée à former une membrane suspendue du dispositif 300, ainsi qu'une première partie 311 de la couche sacrificielle 304 également entourée par la tranchée 308. Cette tranchée 308 est réalisée sur une largeur comprise entre environ 1 µm et 2 µm, par exemple par une gravure ionique réactive.

Comme représenté sur la figure 31, on peut réaliser une épitaxie non sélective par rapport au matériau de la couche sacrificielle 304, formant ainsi, sur la couche 306, une couche supérieure de silicium 312 dont l'épaisseur correspond à celle souhaitée pour la réalisation de la membrane suspendue. De plus, la tranchée 308 est également remplie par le matériau épitaxié 312.

On réalise ensuite une planarisation mécano-chimique de la couche épitaxiée 312 pour obtenir l'épaisseur de silicium souhaitée pour la membrane suspendue (figure 32).

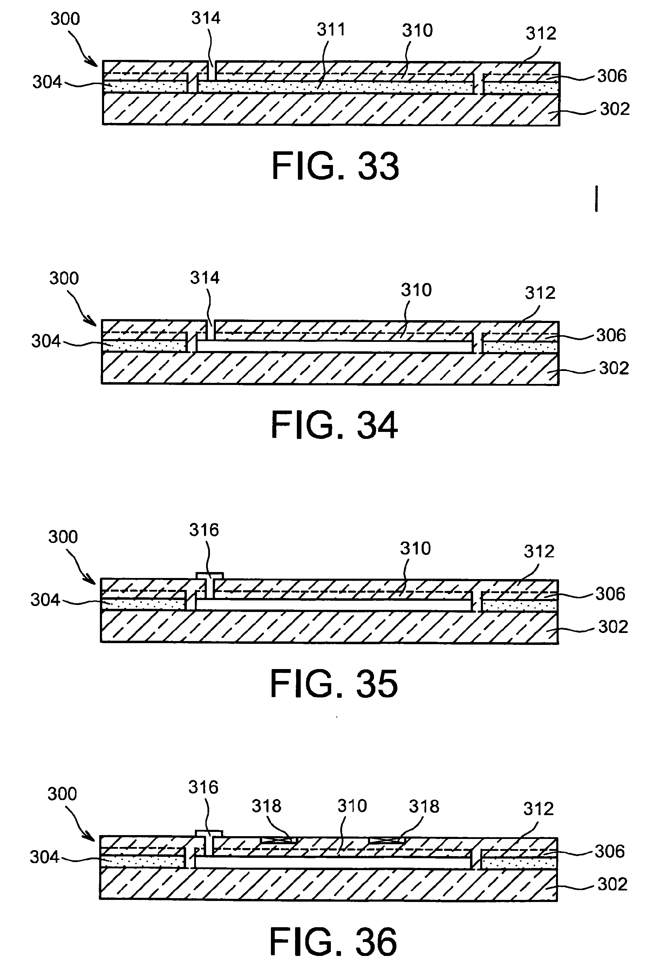

Comme dans les précédents modes de réalisation, une ouverture 314 est gravée dans la couche épitaxiée 312 et la première partie 310 de la couche de semi-conducteur 306, permettant d'accéder à la première partie 311 de la couche sacrificielle 304 (figure 33).

Comme représenté sur la figure 34, on grave alors la partie 311 de la couche sacrificielle 304 se trouvant délimitée par la tranchée 308. Dans ce troisième mode de réalisation, c'est le matériau épitaxié 312, ici du silicium, qui forme le matériau d'arrêt de gravure. Cette gravure peut être réalisée avec une solution aqueuse à base de HF.

Comme dans le second mode de réalisation, l'ouverture 314 est bouchée en réalisant un dépôt et une gravure d'un matériau 316 tel que du verre de phosphosilicate (PSG) (figure 35). Un fluage peut ensuite être réalisé par un recuit PSG à une température supérieure à 1000°C.

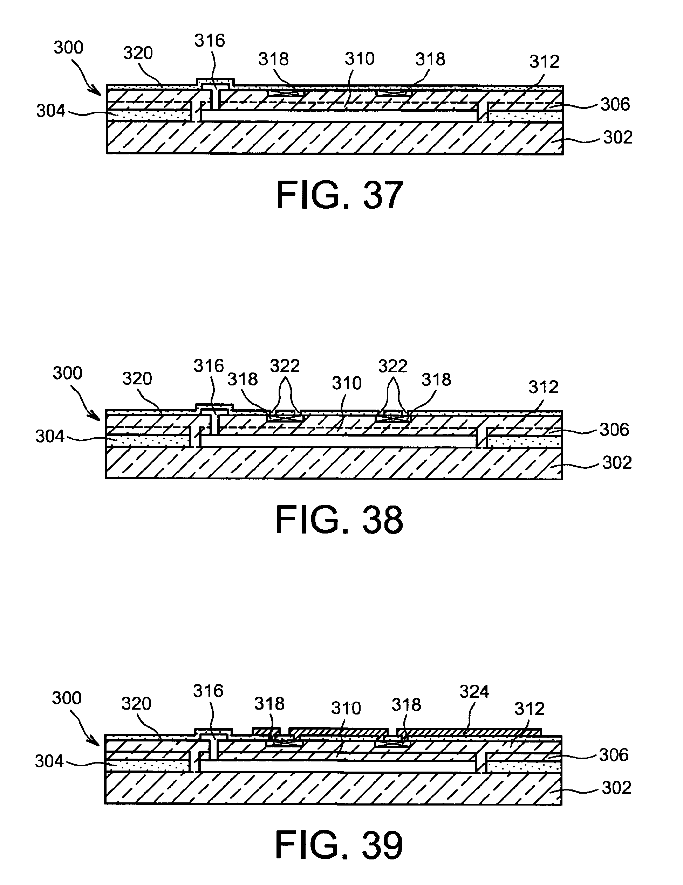

On réalise ensuite une implantation ionique formant des jauges piézorésistives 318 dans la couche épitaxiée 312 (figure 36). Le dispositif 300 est ensuite passivé par le dépôt d'une couche de passivation 320 (figure 37).

On réalise alors des trous de contact 322 dans la couche de passivation 320, au niveau des jauges 318 (figure 38).

Le dispositif 300 est alors terminé en réalisant des pistes métalliques d'interconnexion 324, comme représenté sur la figure 39, venant contacter les jauges 318.

Dans les trois modes de réalisation décrits, chaque tranchée délimitant une partie de la couche de semi-conducteur destinée à former une membrane suspendue du dispositif est entièrement remplie par le matériau d'arrêt de gravure destiné à stopper la gravure d'un matériau sacrificiel. Dans une variante de ces trois modes de réalisation, la tranchée peut tout d'abord être partiellement remplie par un premier matériau, formant une couche, par exemple d'épaisseur sensiblement uniforme, sur les parois à l'intérieur de la tranchée, et de déposer ensuite dans l'espace restant dans la tranchée, sur la couche du matériau d'arrêt de gravure, un second matériau, par exemple obtenu par épitaxie, et pouvant former une partie de la membrane suspendue. Le premier matériau peut par exemple être un diélectrique tel que du SiO₂ et/ou du SiN, le second matériau épitaxié pouvant être du silicium. Dans ce cas, la couche de SiO₂ a notamment pour fonction principale d'isoler électriquement le substrat de la couche épitaxiée. Elle doit être suffisamment résistante à l'agent de gravure de la couche sacrificielle mais le rôle d'arrêt de gravure est rempli par le silicium épitaxié présent dans la tranchée.

Dans les exemples décrits précédemment, les dépôts de matériaux dans les tranchées s'effectuent sur les parois « verticales » des tranchées, et non à partir du fond des tranchées. La vitesse de dépôt sur ces parois « verticales » étant plus faible que celle sur des surfaces « horizontales », par exemple la paroi de fond des tranchées, l'épaisseur à déposer pour remplir une tranchée est généralement égale à la largeur de la tranchée. La largeur des tranchées est donc choisie pour être compatible avec l'épaisseur maximale du matériau d'arrêt de gravure pouvant être déposée dans les tranchées.

Lorsque les tranchées ont une largeur supérieure à l'épaisseur maximale du matériau d'arrêt de gravure pouvant être déposée dans les tranchées, le remplissage des tranchées peut être obtenu par un premier dépôt d'un matériau d'arrêt de gravure, puis par au moins un second dépôt d'un autre matériau dans les tranchées. Lorsque le matériau résistant au dit agent de gravure disposé dans la tranchée est électriquement conducteur, le remplissage de la tranchée peut être réalisé par un premier dépôt d'un matériau diélectrique et par un deuxième dépôt dudit matériau résistant au dit agent de gravure.

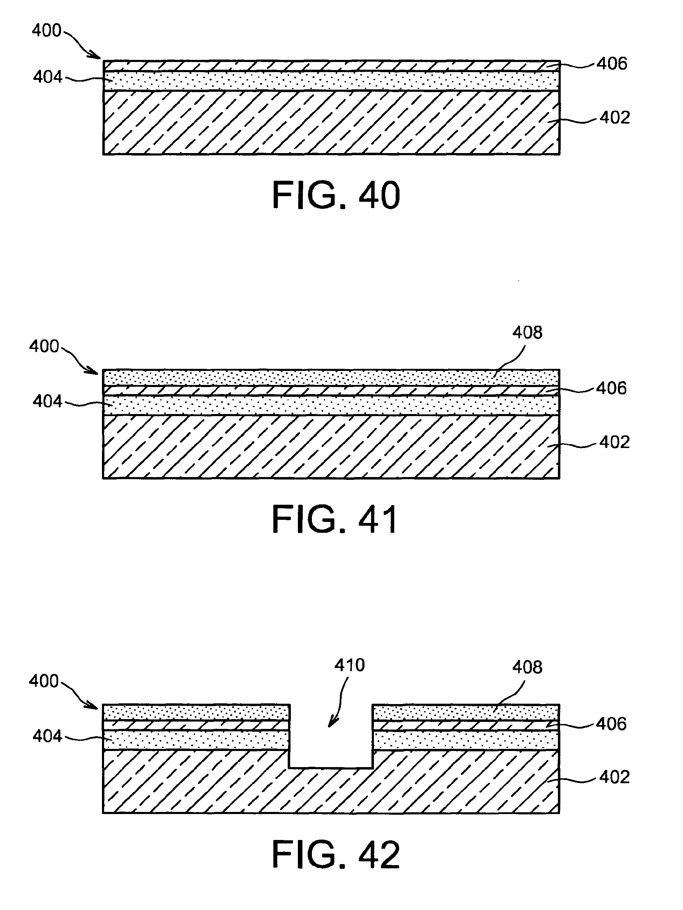

Les figures 40 à 47 représentent les étapes d'un exemple d'un tel remplissage des tranchées d'un dispositif à membrane suspendue 400. Cet exemple de remplissage peut notamment être mis en oeuvre au cours d'un des procédés de réalisation des dispositifs à membrane suspendue décrits précédemment.

Comme représenté sur la figure 40, le dispositif 400 est réalisé à partir d'un substrat 402 à base d'au moins un semi-conducteur, par exemple du silicium, sur lequel sont empilées une couche diélectrique 404, par exemple à base de SiO₂ et formant une couche sacrificielle, et une couche mince 406 à base de semi-conducteur, par exemple du silicium.

On réalise un dépôt d'une couche diélectrique 408, par exemple à base de SiO₂, sur la couche mince de silicium 406 (figure 41).

Une tranchée 410 est ensuite gravée à travers les couches 408, 406, 404, et également en partie dans le substrat 402 (figure 42). Comme dans les procédés de réalisation de dispositif à membrane suspendue décrits précédemment, la tranchée 410 forme un tracé continu, entourant complètement et délimitant une portion de la couche mince 406 destinée à former au moins une partie d'une membrane suspendue du dispositif 400.

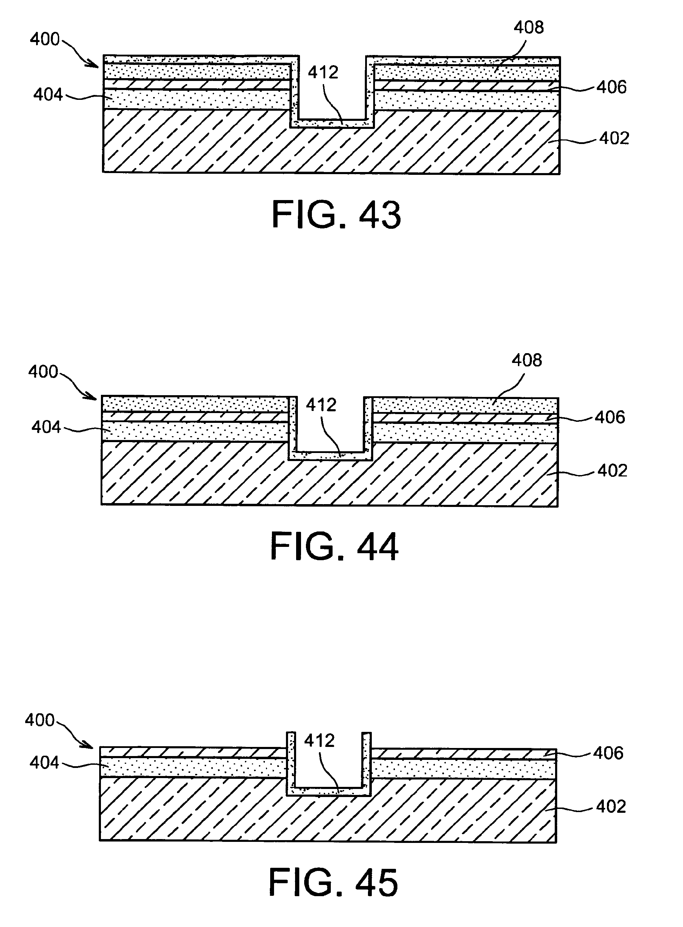

Comme représenté sur la figure 43, une couche 412 à base d'un matériau résistant à la gravure, par exemple diélectrique, est déposée dans la tranchée 410 et sur la couche diélectrique 408. Un polissage permet ensuite de supprimer les parties de cette couche 412 se trouvant sur la couche diélectrique 408 (figure 44). La couche diélectrique 408 est alors supprimée par exemple par gravure (figure 45).

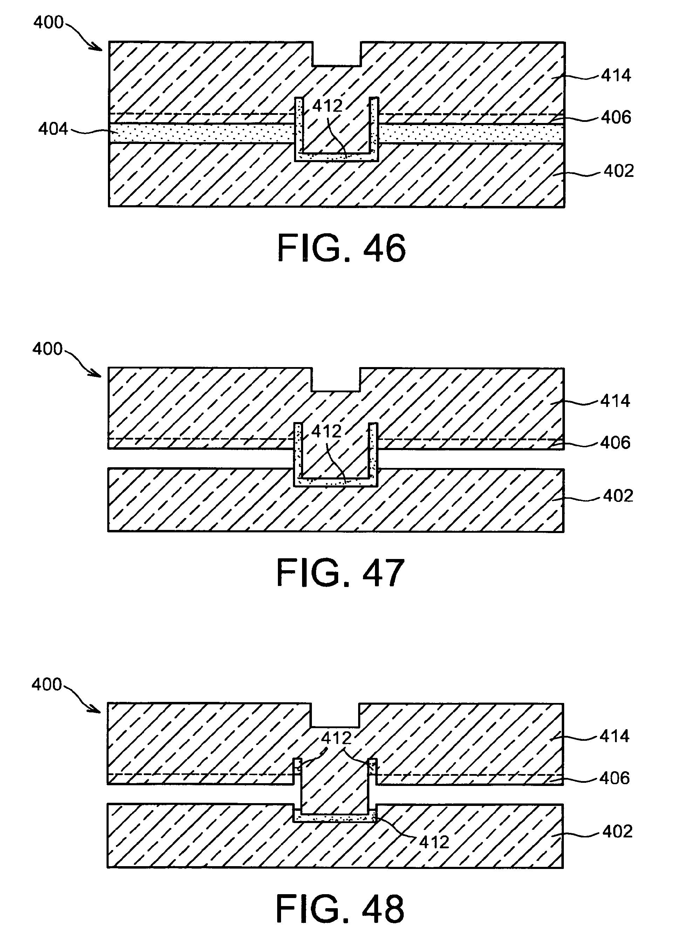

Comme représenté sur la figure 46, on réalise alors une croissance par épitaxie sur la couche mince 406, formant une couche 414 à base du matériau de la couche mince 406, c'est-à-dire polycristallin ou monocristallin, au niveau de la couche mince 406. L'épitaxie est également réalisée au niveau de la tranchée 410, c'est-à-dire sur le matériau résistant à la gravure 412.

Enfin, la couche diélectrique 404 est gravée, par exemple par une gravure HF. La présence du matériau 412 permet de conserver le matériau épitaxié 414 au niveau de la tranchée 410 précédemment réalisée, formant ainsi un ancrage au substrat 402 (figure 47).

Dans une variante, le matériau 412 peut ne pas être résistant à l'agent de gravure utilisé pour graver la couche diélectrique 404, et être par exemple un simple matériau diélectrique. Ce matériau permet notamment d'assurer une fonction d'isolation électrique entre le substrat et la couche épitaxiée 414 au niveau de l'ancrage réalisé. Dans ce cas, les portions de la couche 414 se trouvant au niveau de la couche diélectrique 404 sont alors gravées lors de la gravure de la couche diélectrique 404, comme représenté sur la figure 48, l'arrêt de gravure étant effectué par le silicium épitaxié de la couche 414, au niveau de la tranchée 410 précédemment réalisée.

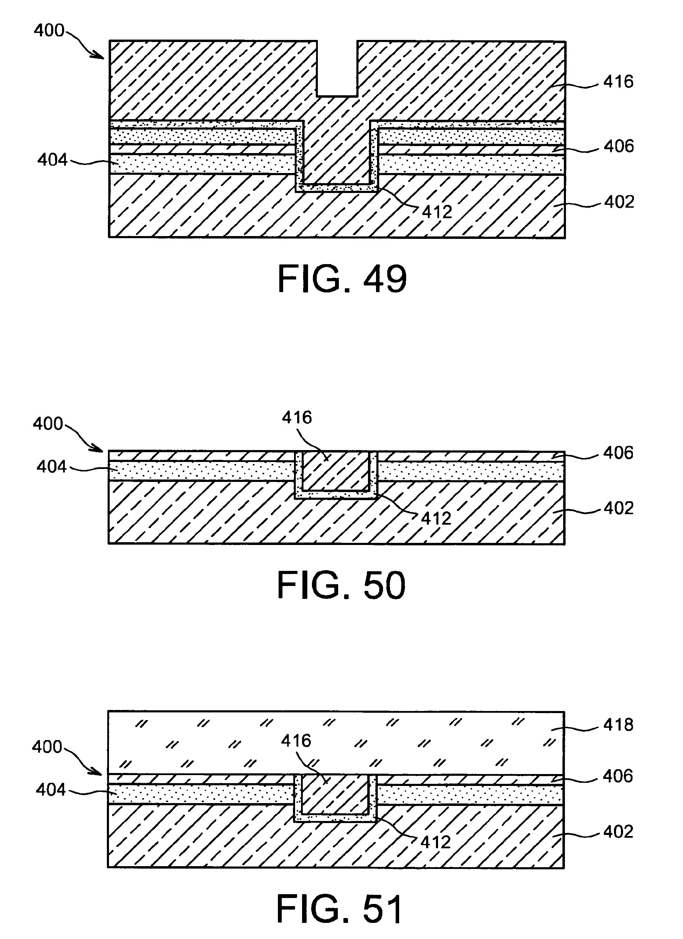

Un autre exemple de remplissage de tranchée du dispositif à membrane suspendue 400 va maintenant être décrit en liaison avec les figures 49 à 54 représentant une partie des étapes d'un tel remplissage.

On réalise tout d'abord les étapes décrites précédemment en liaison avec les figures 40 à 43.

Comme représenté sur la figure 49, on réalise un dépôt épais de silicium polycristallin 416 sur la couche diélectrique 412, au niveau de la tranchée 410 et au niveau de la couche mince 406. On entend par un dépôt épais le dépôt d'une couche dont l'épaisseur est au moins égale à la profondeur de la tranchée 410.

On réalise alors une planarisation avec arrêt au niveau de la couche mince 406 (figure 50). Ainsi, seule la portion de la couche 416 se trouvant dans la tranchée 410 est toujours présente. Cette planarisation supprime également la couche diélectrique 408 ainsi que les portions de la couche diélectrique 412 ne se trouvant dans la tranchée 410.

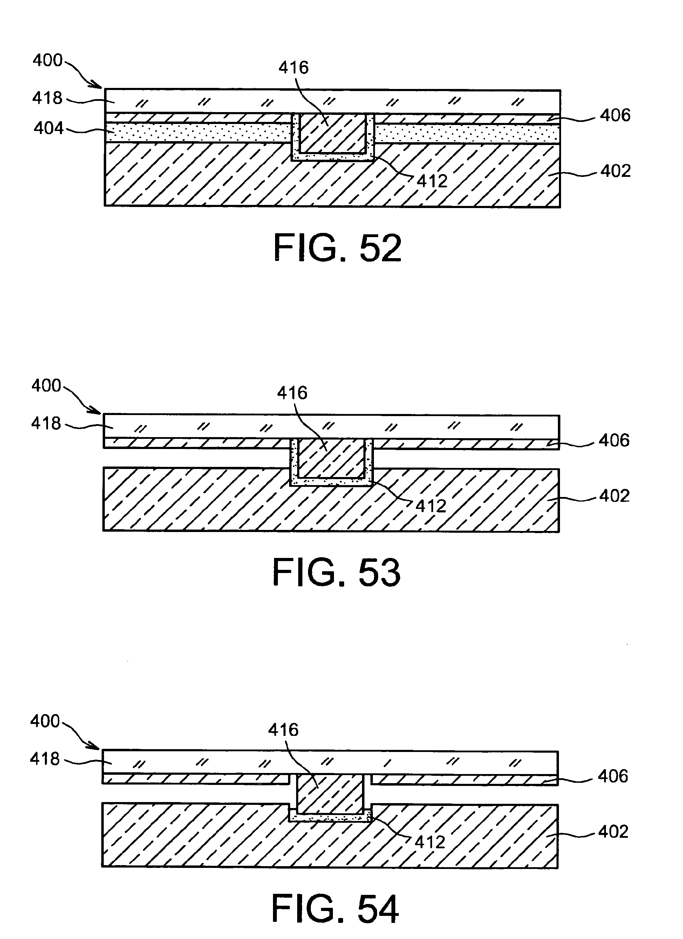

Comme représenté sur la figure 51, un substrat 418, ici à base de silicium monocristallin, est reporté par collage sur le dispositif 400, c'est-à-dire sur la couche mince 406 et sur les portions restantes des couches 412 et 416. Ce substrat 418 est ensuite aminci en fonction de l'épaisseur souhaitée pour la membrane suspendue du dispositif 400 (figure 52).

Enfin, la couche diélectrique 404 est gravée, libérant ainsi la membrane suspendue et formant un ancrage de celle-ci au substrat 402 grâce aux portions restantes des couches 412 et 416 (figure 53).

Comme pour le précédent exemple de remplissage de tranchée, il est possible que la couche 412 soit à base d'un matériau qui ne soit pas résistant à l'agent de gravure utilisé pour supprimer la couche diélectrique 404, mais par exemple un simple matériau diélectrique. Dans ce cas, comme représenté sur la figure 54, les portions de la couche diélectrique 412 exposées à l'agent de gravure utilisé pour supprimer la couche diélectrique 404 sont également gravées, le matériau 416 jouant alors le rôle de matériau d'arrêt de gravure. Le matériau 412 réalise donc ici une fonction d'isolation électrique entre le matériau d'ancrage 416 et le substrat 402.

## Revendications

1. Procédé de réalisation d'un dispositif (100, 200, 300) à au moins une membrane suspendue, comportant au moins les étapes suivantes :
- réalisation d'une tranchée (108, 220, 308) à travers une première couche sacrificielle (104, 210, 304) et une seconde couche (106, 218, 306) disposée sur la première couche sacrificielle (104, 210, 304), la tranchée (108, 220, 308) entourant complètement au moins une partie (111, 221, 311) de la première couche sacrificielle (104, 210, 304) et au moins une partie (110, 222, 310) de la seconde couche (106, 218, 306),
- remplissage de tout ou partie de la tranchée (108, 220, 308) par au moins un matériau (116, 228, 312) apte à résister à au moins un agent de gravure,
- gravure de ladite partie (111, 221, 311) de la première couche sacrificielle (104, 210, 304) par ledit agent de gravure à travers au moins une ouverture (118, 232, 314) réalisée dans la seconde couche (106, 218, 306),
ladite partie (110, 222, 310) de la seconde couche (106, 218, 306) formant au moins une partie de la membrane suspendue.

2. Procédé selon la revendication 1, la seconde couche (106, 218, 306) comportant au moins un matériau semi-conducteur dont au moins une partie est monocristallin.

3. Procédé selon l'une des revendications précédentes, comportant en outre, avant l'étape de réalisation de la tranchée (108), une étape de réalisation d'au moins une électrode (105) sous lesdites parties (110, 111) de la première couche sacrificielle (104) et de la seconde couche (106) par implantation ionique dans une troisième couche (102), la première couche sacrificielle (104) et la seconde couche (106) étant disposées sur cette troisième couche (102).

4. Procédé selon l'une des revendication 1 ou 2, comportant en outre, avant l'étape de réalisation de la tranchée (220), une étape de réalisation d'au moins une électrode (209) par au moins un dépôt d'un matériau électriquement conducteur apte à résister au moins au dit agent de gravure sur une troisième couche (206) à base d'un matériau apte à résister au moins au dit agent de gravure, la première couche sacrificielle (210) et la seconde couche (218) étant disposées sur la troisième couche (206), ladite partie (221) de la première couche sacrificielle (210) étant disposée au moins sur une partie de l'électrode (209).

5. Procédé selon l'une des revendications précédentes, comportant en outre, entre l'étape de remplissage de la tranchée (108, 220) et l'étape de gravure de ladite partie (111, 221) de la première couche sacrificielle (104, 210), une étape d'épitaxie non sélective sur la seconde couche (106, 218) et sur le matériau (116, 228) disposé dans la tranchée (108, 220).

6. Procédé selon l'une des revendications 1 à 4, comportant en outre, entre l'étape de remplissage de la tranchée (108, 220) et l'étape de gravure de ladite partie (111, 221) de la première couche sacrificielle (104, 210), une étape de report d'un matériau sur la seconde couche (106, 218) et sur le matériau (116, 228) disposé dans la tranchée (108, 220).

7. Procédé selon la revendication 6, le matériau reporté étant au moins en partie monocristallin.

8. Procédé selon l'une des revendications 1 à 4, le remplissage de la tranchée (308) étant obtenu par une étape d'épitaxie non sélective sur la seconde couche (306) et dans la tranchée (308).

9. Procédé selon l'une des revendications précédentes, comportant en outre, après l'étape de gravure, une étape de dépôt d'une couche de passivation (236) sur le dispositif (200).

10. Procédé selon l'une des revendications précédentes, comportant en outre, après l'étape de gravure, une étape de réalisation de contacts (238, 240, 318) reliés électriquement à ladite partie (222, 310) de la seconde couche (218, 306) et/ou, lorsque le procédé comporte une étape de réalisation d'une électrode (105, 209), à l'électrode (105, 209).

11. Procédé selon l'une des revendications précédentes, le matériau (116, 228) disposé dans la tranchée étant un matériau diélectrique.

12. Procédé selon l'une des revendications 1 à 10, le remplissage de la tranchée (108, 220, 308) étant obtenu par au moins un premier dépôt du matériau résistant au dit agent de gravure et par un deuxième dépôt d'un autre matériau dans la tranchée (108, 220, 308).

13. Procédé selon l'une des revendications 1 à 10, le remplissage de la tranchée (108, 220, 308) étant réalisé par un premier dépôt d'un matériau diélectrique et par un deuxième dépôt du matériau résistant au dit agent de gravure.

## Claims

1. Method for producing a device (100, 200, 300) with at least one suspended membrane, comprising at least the following steps:
- producing a trench (108, 220, 308) through a first sacrificial layer (104, 210, 304) and a second layer (106, 218, 306) deposited on the first sacrificial layer (104, 210, 304), the trench (108, 220, 308) completely surrounding at least a portion (111, 221, 311) of the first sacrificial layer (104, 210, 304) and at least a portion (110, 222, 310) of the second layer (106, 218, 306),
- filling all or a portion of the trench (108, 220, 308) with at least one material (116, 228, 312) capable of resisting at least one etching agent,
- etching said portion (111, 221, 311) of the first sacrificial layer (104, 210, 304) with said etching agent through at least one opening (118, 232, 314) made in the second layer (106, 218, 306),
said portion (110, 222, 310) of the second layer (106, 218, 306) forming at least one portion of the suspended membrane.

2. Method according to claim 1, the second layer (106, 218, 306) comprising at least one semiconductor material at least a portion of which is monocrystalline.

3. Method according to one of the preceding claims, further comprising, prior to the trench-producing step (108), a step of producing at least one electrode (105) beneath said portions (110, 111) of the first sacrificial layer (104) and second layer (106), via ion implantation in a third layer (102), the first sacrificial layer (104) and the second layer (106) being deposited on this third layer (102).

4. Method according to one of claims 1 or 2, further comprising, prior to the trench (220) production step, a step of producing at least one electrode (209) via at least one deposit of an electrically conductive material capable of resisting at least said etching agent, on a third layer (206) containing a material capable of resisting at least said etching agent, the first sacrificial layer (210) and second layer (218) being deposited on the third layer (206), said portion (221) of the first sacrificial layer (210) being deposited over at least a portion of the electrode (209).

5. Method according to one of the preceding claims, further comprising, between the step of filling the trench (108, 220) and the step of etching said portion (111, 221) of the first sacrificial layer (104, 210), a step of non-selective epitaxy on the second layer (106, 218) and on the material (116, 228) deposited in the trench (108, 220).

6. Method according to one of claims 1 to 4, further comprising, between the step of filling the trench (108, 220) and the step of etching said portion (111, 221) of the first sacrificial layer (104, 210), a step of transferring a material onto the second layer (106, 218) and onto the material (116, 228) arranged inside the trench (108, 220).

7. Method according to claim 6, the transferred material being at least partially monocrystalline.

8. Method according to one of claims 1 to 4, filling of the trench (308) being obtained via a step of non-selective epitaxial growth on the second layer (306) and inside the trench (308).

9. Method according to one of the preceding claims, further comprising, after the etching step, a step of depositing a passivation layer (236) onto the device (200).

10. Method according to one of the preceding claims, further comprising, after the etching step, a step for producing contacts (238, 240, 318) electrically connected to said portion (222, 310) of the second layer (218, 306), and/or to the electrode (105, 209) when the method comprises a step for producing an electrode (105, 209).

11. Method according to one of the preceding claims, the material (116, 228) arranged inside the trench being a dielectric material.

12. Method according to one of claims 1 to 10, the trench (108, 220, 308) being filled by at least a first deposit of the material resistant to said etching agent and by a second deposit of another material inside the trench (108, 220, 308).

13. Method according to one of claims 1 to 10, the trench (108, 220, 308) being filled by a first deposit of a dielectric material and by a second deposit of the material resistant to said etching agent.

## Patentansprüche

1. Verfahren zur Herstellung einer Vorrichtung (100, 200, 300) mit wenigstens einer hängend angeordneten Membran, das Verfahren umfassend die folgenden Schritte bzw. Stufen:
- Ausbilden eines Grabens (108, 220, 308) durch wenigstens eine erste verlorene oder Opferschicht (104, 210, 304) und eine auf der ersten verlorenen bzw. Opferschicht (104, 210, 304) angeordnete zweite Schicht (106, 218, 306) hindurch, wobei der Graben (108, 220, 308) wenigstens einen Teil (111, 221, 311) der ersten verlorenen bzw. Opferschicht (104, 210, 304) und wenigstens einen Teil (110, 222, 310) der zweiten Schicht (106, 218, 306) vollständig umgibt,
- ganzes oder teilweises Ausfüllen des Grabens (108, 220, 308) mit wenigstens einem gegen wenigstens ein Ätzmittel beständigen bzw. resistenten Material (116, 228, 312),
- Ätzen des genannten Teils (111, 221, 311) der ersten verlorenen bzw. Opferschicht (104, 210, 304) mit dem genannten Ätzmittel durch wenigstens eine in der zweiten Schicht (106, 218, 306) erzeugte Öffnung (118, 232, 314) hindurch,
wobei der genannte Teil (110, 222, 310) der zweiten Schicht (106, 218, 306) wenigstens einen Teil der hängend angeordneten Membran bildet.

2. Verfahren nach Anspruch 1, bei welchem die zweite Schicht (106, 218, 306) wenigstens ein Halbleitermaterial umfaßt, von dem wenigstens ein Teil monokristallin ist.

3. Verfahren nach einem der vorhergehenden Ansprüche, das vor der Verfahrensstufe der Ausbildung des Grabens (108) des weiteren eine Verfahrensstufe der Ausbildung wenigstens einer Elektrode (108) unterhalb den genannten Teilen (110, 111) der ersten verlorenen bzw. Opferschicht (104) und der zweiten Schicht (106) mittels Ionenimplantation in einer dritten Schicht (102) umfaßt, wobei die erste verlorene bzw. Opferschicht (104) und die zweite Schicht (106) auf dieser dritten Schicht (102) angeordnet sind.

4. Verfahren nach einem der Ansprüche 1 oder 2, das vor der Verfahrensstufe der Ausbildung des Grabens (220) des weiteren eine Verfahrensstufe der Ausbildung wenigstens einer Elektrode (209) mittels wenigstens einer Abscheidung eines elektrisch leitenden, gegenüber wenigstens dem genannten Ätzmittel beständigen bzw. resistenten Materials auf einer dritten Schicht (206) auf Basis eines wenigstens gegenüber dem genannten Ätzmittel beständigen bzw. resistenten Materials umfaßt, wobei die erste verlorene bzw. Opferschicht (214) und die zweite Schicht (218) auf der dritten Schicht (206) angeordnet sind und der genannte Teil (221) der ersten verlorenen bzw. Opferschicht (210) wenigstens auf einem Teil der Elektrode (209) angeordnet ist.

5. Verfahren nach einem der vorhergehenden Ansprüche, das zwischen der Verfahrensstufe des Auffüllens des Grabens (108, 220) und der Stufe des Ätzens des genannten Teils (111, 221) der ersten verlorenen bzw. Opferschicht (104, 210) des weiteren eine Verfahrensstufe nicht-selektiven Epitaxialwachstums auf der zweiten Schicht (106, 218) und auf dem in dem Graben (108, 220) angeordneten Material (116, 228) umfaßt.

6. Verfahren nach einem der Ansprüche 1 bis 4, das zwischen der Verfahrensstufe der Füllung des Grabens (108, 220) und der Verfahrensstufe des Ätzens des genannten Teils (111, 221) der ersten verlorenen bzw. Opferschicht (104, 210) des weiteren eine Verfahrensstufe des Auftrags eines Materials auf der zweiten Schicht (106, 218) und auf dem in dem Graben (108, 220) angeordneten Material (116, 228) umfaßt.

7. Verfahren nach Anspruch 6, bei welchem das aufgetragene Material wenigstens zum Teil monokristallin ist.

8. Verfahren nach einem der Ansprüche 1 bis 4, bei welchem das Füllen des Grabens (308) mittels einer Stufe nicht-selektiven Epitaxialwachstums auf der zweiten Schicht (306) und in dem Graben (308) erfolgt.

9. Verfahren nach einem der vorhergehenden Ansprüche, das nach der Ätzstufe des weiteren eine Verfahrensstufe der Abscheidung einer Passivierungsschicht (236) auf der Vorrichtung (200) umfaßt.

10. Verfahren nach einem der vorhergehenden Ansprüche, das nach der Ätzstufe des weiteren eine Verfahrensstufe der Ausbildung von Kontakten (238, 240, 318) umfaßt, die elektrisch mit dem genannten Teil (222, 310) der zweiten Schicht (218, 306) und, falls das Verfahren eine Verfahrensstufe der Ausbildung einer Elektrode (105, 209) umfaßt, mit der Elektrode (105, 209) verbunden sind.

11. Verfahren nach einem der vorhergehenden Ansprüche, bei welchem das in dem Graben angeordnete Material (116, 228) ein dielektrische Material ist.

12. Verfahren nach einem der Ansprüche 1 bis 10, bei welchem das Füllen des Grabens (108, 220, 308) mittels wenigstens einer ersten Abscheidung des gegenüber dem genannten Ätzmittel beständigen bzw. resistenten Materials sowie mittels einer zweiten Abscheidung eines anderen Materials in dem Graben (108, 220, 308) erfolgt.

13. Verfahren nach einem der Ansprüche 1 bis 10, bei welchem das Füllen des Grabens (108, 220, 308) mittels einer ersten Abscheidung eines dielektrischen Materials und mittels einer zweiten Abscheidung des gegen das genannte Ätzmittel beständigen bzw. resistenten Materials erfolgt.
